# EUROPEAN PATENT APPLICATION

(11) **EP 4 199 080 A1**
(43) Date of publication of application: **21.06.2023**
(21) Application number: 22205977.6
(22) Date of filing: 08.11.2022
(51) Int. Cl.: H01L 23/528, H01L 23/535, H01L 23/48, H01L 29/78, H01L 21/768

(54) **SIGNAL ROUTING USING STRUCTURES BASED ON BURIED POWER RAILS**

(30) Priority: 15.12.2021 US 202117552010
(71) Applicant: Intel Corporation, Santa Clara, CA 95054 (US)
(72) Inventor: Ostermayr, Martin, 85457 Woerth (DE); Herold, Klaus, 81825 Munich (DE); Singer, Joachim, 80638 Munich (DE); Wagner, Thomas, 91189 Regelsbach (DE)
(74) Representative: Goddar, Heinz J.

(57) **Abstract**

Signal routing using structures based on buried power rails (BPRs) is described. An example IC device includes a support structure, a plurality of IC components provided over the support structure, and first and second electrically conductive structures having respective portions that are buried in the support structure, such structures referred to as "buried signal rails" (BSRs). The first BSR may be electrically coupled to a terminal of one of the plurality of IC components, the second BSR may be electrically coupled to a terminal of another one of the plurality of IC components, and the IC device may further include a bridge interconnect embedded within the support structure, the bridge interconnect having a first end in contact with the first BSR and a second end in contact with the second BSR. Implementing BSRs in IC devices may allow significantly increasing standard cell library density and provide geometry-free signal routing.

## Description

### Background

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize the performance of each device and each interconnect becomes increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example fin-based field-effect transistor (FinFET), according to some embodiments of the present disclosure.
FIG. 2 provides a cross-sectional side view of an integrated circuit (IC) device implementing signal routing using structures based on buried power rails (BPRs), according to some embodiments of the present disclosure.
FIG. 3 provides a cross-sectional side view of an IC device implementing signal routing using structures based on BPRs, according to other embodiments of the present disclosure.
FIG. 4 provides a cross-sectional side view of an IC device implementing signal routing using structures based on BPRs, according to yet other embodiments of the present disclosure.
FIG. 5 provides a flow diagram of an example method of manufacturing an IC device implementing signal routing using structures based on BPRs, according to some embodiments of the present disclosure.
FIG. 6 provides top views of, respectively, a wafer and dies that may include one or more IC devices implementing signal routing using structures based on BPRs, in accordance with various embodiments.
FIG. 7 is a cross-sectional side view of an IC package that may include one or more IC devices implementing signal routing using structures based on BPRs, in accordance with various embodiments.
FIG. 8 is a cross-sectional side view of an IC device assembly that may include one or more IC devices implementing signal routing using structures based on BPRs, in accordance with various embodiments.
FIG. 9 is a block diagram of an example computing device that may include one or more IC devices implementing signal routing using structures based on BPRs, in accordance with various embodiments.

### Detailed Description

The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

For purposes of illustrating signal routing using structures based on BPRs, described herein, it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

As described above, the scaling of features in ICs, e.g., scaling of transistors and interconnects, has been a driving force behind an ever-growing semiconductor industry. Relentless scaling of transistors and interconnects in advanced semiconductor technologies has not only resulted in major process-related challenges but has also imposed severe design challenges. Dimensional scaling of designs has been made possible by (i) Front-End-of-Line (FEOL) and Back-End-of-Line (BEOL) pitch scaling, which worsens short-channel effects in transistors and increases wire/contact resistances; and, (ii) fin depopulation in standard cells, which causes degradation of transistor drive. To enable further area scaling in future nodes, an approach of burying the power rails into the substrate has been proposed, which no longer requires reserving two routing tracks for power nets (e.g., VDD or VSS) in the standard cell area. Generally, such an approach includes replacing at least some of the power lines which conventionally run at Mint level with power lines that are "buried" within the shallow trench isolation (STI) and the support structure (e.g., a substrate, a die, a wafer, or a chip). Such power lines are called BPRs. BPRs free up routing resources at Mint level, resulting in standard cell height reduction and overall area scaling. Additionally, BPRs can achieve a higher aspect ratio, thus, exhibiting lower resistance than local level BEOL power rails. Thus, BPRs can be a key scaling booster for complementary metal-oxide-semiconductor (CMOS) extension beyond the 5-nm node.

Signal routing using structures based on BPRs is described. In particular, embodiments of the present disclosure are based on recognition that processes used to fabricate BPRs in IC devices may be extended to provide structures for routing of signals between various IC components of an IC device. An example IC device includes a support structure (e.g., a substrate, a wafer, a chip, or a die) a plurality of IC components provided over the support structure, and first and second electrically conductive structures having respective portions that are buried in the support structure. The first and second structures may be similar to BPRs in their dimensions and the way they are fabricated, but used for routing of signals between, to, and from various IC components of an IC device and, therefore, may be referred to as buried signal rails (BSRs). The first BSR may be electrically coupled to a terminal of one of the plurality of IC components, the second BSR may be electrically coupled to a terminal of another one of the plurality of IC components, and the IC device may further include a bridge interconnect (e.g., a lateral interconnect) embedded within the support structure, the bridge interconnect having a first end in contact with the first BSR and a second end in contact with the second BSR. Implementing BSRs in IC devices may allow significantly increasing standard cell library density and advantageously provide geometry-free signal routing (e.g., routing of signals substantially independent of the physical layout of the IC components implemented in the IC devices).

IC devices as described herein, in particular IC devices implementing signal routing using structures based on BPRs, may be implemented in one or more IC components (i.e., components associated with an IC) or/and between various such components. In various embodiments, IC components include, for example, transistors, diodes, power sources, resistors, capacitors, inductors, sensors, transceivers, receivers, antennas, etc. IC components may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC devices as described herein may be included in a radio frequency IC (RFIC), which may, e.g., be included in any component associated with an IC of a radio frequency (RF) receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC devices as described herein may be included in memory devices or circuits. In some embodiments, IC devices as described herein may be employed as part of a chipset for executing one or more related functions in a computer.

In the following description, references are made to the accompanying drawings that form a part hereof, and in which is shown, by way of illustration, embodiments that may be practiced. The accompanying drawings are not necessarily drawn to scale. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the manufacturing processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC devices implementing signal routing using structures based on BPRs as described herein.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations.

In the following detailed description, various aspects of the illustrative implementations may be described using terms commonly employed by those skilled in the art to convey the substance of their work to others skilled in the art. For example, some descriptions may refer to a particular source or drain region or contact being either a source region/contact or a drain region/contact. However, unless specified otherwise, which region/contact of a transistor is considered to be a source region/contact and which region/contact is considered to be a drain region/contact is not important because under certain operating conditions, designations of source and drain are often interchangeable. Therefore, descriptions provided herein may refer to a source or drain (S/D) region/contact to indicate that the region/contact can be either a source region/contact or a drain region/contact. In another example, the term "high-k dielectric" refers to a material having a higher dielectric constant (k) than silicon oxide, while the term "low-k dielectric" refers to a material having a lower k than silicon oxide. If used, the terms "oxide," "carbide," "nitride," etc. refer to compounds containing, respectively, oxygen, carbon, nitrogen, etc. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

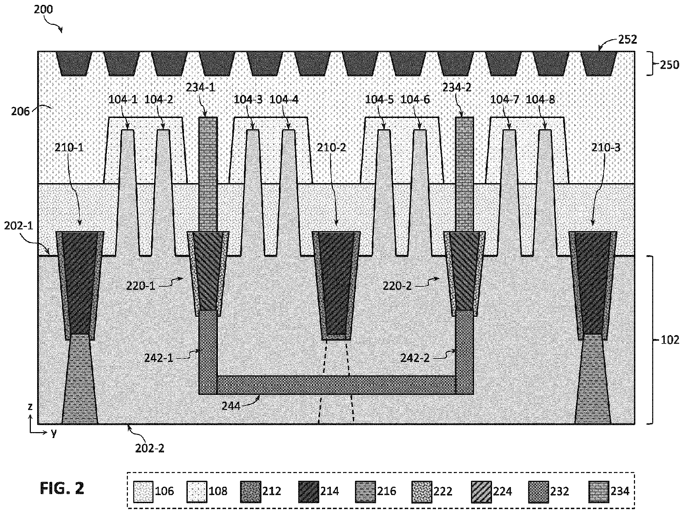

In the following, various embodiments of IC devices implementing signal routing using structures based on BPRs are described with reference to the IC components being transistors and illustrated in FIGS. 2-4 with the transistors being FinFETs. However, in general, IC devices implementing signal routing using structures based on BPRs may include IC components that are FETs other than FinFETs, IC components that are transistors other than FETs (e.g., bipolar junction transistors), and/or IC components that are components other than transistors (e.g., capacitors, diodes, resistors, etc.).

A FET, e.g., a metal-oxide-semiconductor (MOS) FET (MOSFET), is a three-terminal device that includes source, drain, and gate terminals and uses electric field to control current flowing through the device. A FET typically includes a semiconductor channel material, a source and a drain regions provided in the channel material, and a gate stack that includes at least a gate electrode material and may also include a gate dielectric material, the gate stack provided over a portion of the channel material between the source and the drain regions. Because gate electrode materials often include metals, gates of transistors are commonly referred to as "metal gates."

Recently, FETs with non-planar architectures, such as FinFETs (also sometimes referred to as "wrap-around gate transistors" or "tri-gate transistors") and nanoribbon-based transistors (also sometimes referred to as "all-around gate transistors"), have been extensively explored as alternatives to transistors with planar architectures. In comparison to a planar architecture where the transistor channel has only one confinement surface, a non-planar architecture is any type of architecture where the transistor channel has more than one confinement surfaces. A confinement surface refers to a particular orientation of the channel surface that is confined by the gate field. Non-planar transistors potentially improve performance relative to transistors having a planar architecture, such as single-gate transistors.

In a FinFET, a semiconductor structure shaped as a fin extends away from a base (which may be any suitable support structure, e.g., a semiconductor substrate), and a gate stack wraps around the upper portion of the fin (i.e., the portion farthest away from the base), providing the ability to form a gate on three sides of the fin. The portion of the fin around which the gate stack wraps around is referred to as a "channel" or a "channel portion" of a FinFET. A semiconductor material of the channel portion is commonly referred to as a "channel material." A source region and a drain region are provided in the fin on the opposite sides of the gate stack, forming, respectively, a source and a drain of a FinFET.

In a nanoribbon-based transistor, a gate stack may be provided around a portion of an elongated semiconductor structure called "nanoribbon", providing the ability to form a gate on all sides (i.e., on four sides) of the nanoribbon. The "channel" or the "channel portion" of a nanoribbon-based transistor is the portion of the nanoribbon around which the gate stack wraps around. A source region and a drain region are provided in the nanoribbon on each side of the gate stack, forming, respectively, a source and a drain of a nanoribbon-based transistor. As used herein, the term "nanoribbon" refers to an elongated structure of a semiconductor material having a longitudinal axis parallel to a support structure (e.g., a substrate, a die, a chip, or a wafer) over which such a structure is provided. Typically, a length of a such a structure (i.e., a dimension measured along the longitudinal axis, which, in the present drawings, is the x-axis of an example x-y-z coordinate system) is greater than each of a width (i.e., a dimension measured along the y-axis of the example coordinate system shown in the present drawings) and a thickness/height (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon-based transistor" if the channel of the transistor is a portion of a nanoribbon, i.e., a portion around which a gate stack of a transistor may wrap around.

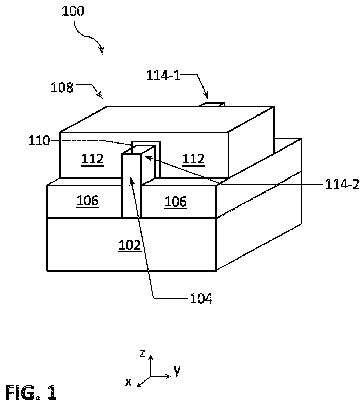

FIG. 1 is a perspective view of an example FinFET 100, according to some embodiments of the disclosure. The FinFET 100 illustrates one example of an IC component to which BSRs as described herein may be coupled to. For example, the FinFET 100 may be a transistor provided along any of the fins 104 illustrated in the IC devices shown in FIGS. 2-4. The FinFET 100 shown in FIG. 1 is intended to show relative arrangement(s) of some of the components therein. In various embodiments, the FinFET 100, or portions thereof, may include other components that are not illustrated (e.g., any further materials, such as spacer materials, surrounding the gate stack of the FinFET 100, electrical contacts to the S/D regions of the FinFET 100, etc.).

As shown in FIG. 1, the FinFET 100 may be provided over a support structure 102, where the support structure 102 may be any suitable support structure on which a transistor may be built, e.g., a substrate, a die, a wafer, or a chip. As also shown in FIG. 1, the FinFET 100 may include a fin 104, extending away from the support structure 102. A portion of the fin 104 that is closest to the support structure 102 may be enclosed by an insulator material 106, commonly referred to as an "STI material" or, simply, "STI." The portion of the fin 104 enclosed on its' sides by the STI 106 is typically referred to as a "subfin portion" or simply a "subfin." As further shown in FIG. 1, a gate stack 108 that includes at least a layer of a gate electrode material 112 and, optionally, a layer of a gate dielectric 110, may be provided over the top and sides of the remaining upper portion of the fin 104 (e.g., the portion above and not enclosed by the STI 106), thus wrapping around the upper-most portion of the fin 104. The portion of the fin 104 over which the gate stack 108 wraps around may be referred to as a "channel portion" of the fin 104 because this is where, during operation of the FinFET 100, a conductive channel may form. The channel portion of the fin 104 is a part of an active region of the fin 104. A first S/D region 114-1 and a second S/D region 114-2 (also commonly referred to as "diffusion regions") are provided on the opposite sides of the gate stack 108, forming source and drain terminals of the FinFET 100.

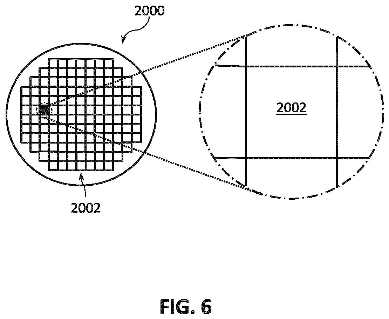

In general, implementations of the present disclosure may be formed or carried out on a support structure such as a semiconductor substrate, composed of semiconductor material systems including, for example, N-type or P-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. In some embodiments, the substrate may be non-crystalline. In some embodiments, the support structure 102 may be a printed circuit board (PCB) substrate. Although a few examples of materials from which the substrate may be formed are described here, any material that may serve as a foundation upon which IC devices implementing signal routing using structures based on BPRs as described herein may be built falls within the spirit and scope of the present disclosure. In various embodiments, the support structure 102 may include any such substrate material that provides a suitable surface for forming the FinFET 100. The support structure 102 may, e.g., be the wafer 2000 of FIG. 6, discussed below, and may be, or be included in, a die, e.g., the singulated die 2002 of FIG. 6, discussed below.

As shown in FIG. 1, the fin 104 may extend away from the support structure 102 and may be substantially perpendicular to the support structure 102. The fin 104 may include one or more semiconductor materials, e.g., a stack of semiconductor materials, so that the upper-most portion of the fin (namely, the portion of the fin 104 enclosed by the gate stack 108) may serve as the channel region of the FinFET 100. Therefore, as used herein, the term "channel material" of a transistor may refer to such upper-most portion of the fin 104, or, more generally, to any portion of one or more semiconductor materials in which a conductive channel between source and drain regions may be formed during operation of a transistor.

As shown in FIG. 1, the STI material 106 may enclose the sides of the fin 104. A portion of the fin 104 enclosed by the STI 106 forms a subfin. In various embodiments, the STI material 106 may be a low-k or high-k dielectric including, but not limited to, elements such as hafnium, silicon, oxygen, nitrogen, titanium, tantalum, lanthanum, aluminum, zirconium, barium, strontium, yttrium, lead, scandium, niobium, and zinc. Further examples of dielectric materials that may be used in the STI material 106 may include, but are not limited to silicon nitride, silicon oxide, silicon dioxide, silicon carbide, silicon nitride doped with carbon, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

Above the subfin portion of the fin 104, the gate stack 108 may wrap around the fin 104 as shown in FIG. 1. In particular, the gate dielectric 110 may wrap around the upper-most portion of the fin 104, and the gate electrode 112 may wrap around the gate dielectric 110. The interface between the channel portion of the fin 104 and the subfin portion of the fin 104 is located proximate to where the gate electrode 112 ends.

The gate electrode 112 may include one or more gate electrode materials, where the choice of the gate electrode materials may depend on whether the FinFET 100 is a P-type metal-oxide-semiconductor (PMOS) transistor or an N-type metal-oxide-semiconductor (NMOS) transistor. For a PMOS transistor, gate electrode materials that may be used in different portions of the gate electrode 112 may include, but are not limited to, ruthenium, palladium, platinum, cobalt, nickel, and conductive metal oxides (e.g., ruthenium oxide). For an NMOS transistor, gate electrode materials that may be used in different portions of the gate electrode 112 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode 112 may include a stack of a plurality of gate electrode materials, where zero or more materials of the stack are workfunction (WF) materials and at least one material of the stack is a fill metal layer. Further materials/layers may be included next to the gate electrode 112 for other purposes, such as to act as a diffusion barrier layer or/and an adhesion layer.

If used, the gate dielectric 110 may include a stack of one or more gate dielectric materials. In some embodiments, the gate dielectric 110 may include one or more high-k dielectric materials. In various embodiments, the high-k dielectric materials of the gate dielectric 110 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric 110 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate dielectric 110 during manufacture of the FinFET 100 to improve the quality of the gate dielectric 110.

In some embodiments, e.g., when the FinFET 100 is a storage transistor of a hysteretic memory cell (i.e., a type of memory that functions based on the phenomenon of hysteresis), the gate dielectric 110 may be replaced with, or complemented by, a hysteretic material. In some embodiments, a hysteretic material may be provided as a layer of a ferroelectric (FE) or an antiferroelectric (AFE) material. Such an FE/AFE material may include one or more materials which exhibit sufficient FE/AFE behavior even at thin dimensions, e.g., such as an insulator material at least about 5% of which, e.g., at least 10% of which, is in an orthorhombic phase and/or a tetragonal phase. For example, such materials may be based on hafnium and oxygen (e.g., hafnium oxides), with various dopants added to ensure sufficient amount of an orthorhombic phase or a tetragonal phase. Some examples of such materials include hafnium zirconium oxide (HfZrO, also referred to as HZO), silicon-doped (Si-doped) hafnium oxide, germanium-doped (Ge-doped) hafnium oxide, aluminum-doped (Al-doped) hafnium oxide, and yttrium-doped (Y-doped) hafnium oxide. However, in other embodiments, any other materials which exhibit FE/AFE behavior at thin dimensions may be used to replace, or to complement, the gate dielectric 110, and are within the scope of the present disclosure. The FE/AFE material included in the gate stack 106 may have a thickness that may, in some embodiments, be between about 0.5 nanometers and 10 nanometers, including all values and ranges therein (e.g., between about 1 and 8 nanometers, or between about 0.5 and 5 nanometers). In other embodiments, a hysteretic material may be provided as a stack of materials that, together, exhibit hysteretic behavior. Such a stack may include, e.g., a stack of silicon oxide and silicon nitride. Unless specified otherwise, descriptions provided herein with respect to the gate dielectric 110 are equally application to embodiments where the gate dielectric 110 is replaced with, or complemented by, a hysteretic material.

In some embodiments, the gate stack 108 may be surrounded by a dielectric spacer, not specifically shown in FIG. 1. The dielectric spacer may be configured to provide separation between the gate stacks 108 of different FinFETs 100 which may be provided along a single fin (e.g., different FinFETs provided along the fin 104, although FIG. 1 only illustrates one of such FinFETs), as well as between the gate stack 108 and the source/drain contacts disposed on each side of the gate stack 108. Such a dielectric spacer may include one or more low-k dielectric materials. Examples of the low-k dielectric materials that may be used as the dielectric spacer include, but are not limited to, silicon dioxide, carbon-doped oxide, silicon nitride, fused silica glass (FSG), and organosilicates such as silsesquioxane, siloxane, and organosilicate glass. Other examples of low-k dielectric materials that may be used as the dielectric spacer include organic polymers such as polyimide, polynorbornenes, benzocyclobutene, perfluorocyclobutane, or polytetrafluoroethylene (PTFE). Still other examples of low-k dielectric materials that may be used as the dielectric spacer include silicon-based polymeric dielectrics such as hydrogen silsesquioxane (HSQ) and methylsilsesquioxane (MSQ). Other examples of low-k materials that may be used in a dielectric spacer include various porous dielectric materials, such as for example porous silicon dioxide or porous carbon-doped silicon dioxide, where large voids or pores are created in a dielectric in order to reduce the overall dielectric constant of the layer, since voids can have a dielectric constant of nearly 1. When such a dielectric spacer is used, then the lower portions of the fin 104, e.g., the subfin portion of the fin 104, may be surrounded by the STI material 106 which may, e.g., include any of the high-k dielectric materials described herein.

In some embodiments, the fin 104 may be composed of semiconductor material systems including, for example, N-type or P-type materials systems. In some embodiments, the fin 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the fin 104 may include a combination of semiconductor materials where one semiconductor material is used for the channel portion and another material, sometimes referred to as a "blocking material," is used for at least a portion of the subfin portion of the fin 104. In some embodiments, the subfin and the channel portions of the fin 104 are each formed of monocrystalline semiconductors, such as silicon or germanium. In a first embodiment, the subfin and the channel portion of the fin 104 are each formed of compound semiconductors with a first sub-lattice of at least one element from group III of the periodic table (e.g., Al, Ga, In), and a second sub-lattice of at least one element of group V of the periodic table (e.g., P, As, Sb). The subfin may be a binary, ternary, or quaternary III-V compound semiconductor that is an alloy of two, three, or even four elements from groups III and V of the periodic table, including boron, aluminum, indium, gallium, nitrogen, arsenic, phosphorus, antimony, and bismuth.

For some example N-type transistor embodiments (i.e., for the embodiments where the FinFET 100 is an NMOS), the channel portion of the fin 104 may advantageously include a III-V material having a high electron mobility, such as, but not limited to InGaAs, InP, InSb, and InAs. For some such embodiments, the channel portion of the fin 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). In some embodiments with highest mobility, the channel portion of the fin 104 may be an intrinsic III-V material, i.e., a III-V semiconductor material not intentionally doped with any electrically active impurity. In alternate embodiments, a nominal impurity dopant level may be present within the channel portion of the fin 104, for example to further fine-tune a threshold voltage Vt, or to provide HALO pocket implants, etc. Even for impurity-doped embodiments however, impurity dopant level within the channel portion of the fin 104 may be relatively low, for example below 10¹⁵ dopant atoms per cubic centimeter (cm⁻³), and advantageously below 10¹³ cm⁻³. The subfin portion of the fin 104 may be a III-V material having a band offset (e.g., conduction band offset for N-type devices) from the channel portion. Example materials include, but are not limited to, GaAs, GaSb, GaAsSb, GaP, InAIAs, GaAsSb, AlAs, AIP, AlSb, and AIGaAs. In some N-type transistor embodiments of the FinFET 100 where the channel portion of the fin 104 is InGaAs, the subfin may be GaAs, and at least a portion of the subfin may also be doped with impurities (e.g., P-type) to a greater impurity level than the channel portion. In an alternate heterojunction embodiment, the subfin and the channel portion of the fin 104 are each, or include, group IV semiconductors (e.g., Si, Ge, SiGe). The subfin of the fin 104 may be a first elemental semiconductor (e.g., Si or Ge) or a first SiGe alloy (e.g., having a wide bandgap).

For some example P-type transistor embodiments (i.e., for the embodiments where the FinFET 100 is a PMOS), the channel portion of the fin 104 may advantageously be a group IV material having a high hole mobility, such as, but not limited to Ge or a Ge-rich SiGe alloy. For some example embodiments, the channel portion of the fin 104 may have a Ge content between 0.6 and 0.9, and advantageously may be at least 0.7. In some embodiments with highest mobility, the channel portion may be intrinsic III-V (or IV for P-type devices) material and not intentionally doped with any electrically active impurity. In alternate embodiments, one or more a nominal impurity dopant level may be present within the channel portion of the fin 104, for example to further set a threshold voltage Vt, or to provide HALO pocket implants, etc. Even for impurity-doped embodiments however, impurity dopant level within the channel portion is relatively low, for example below 10¹⁵ cm⁻³, and advantageously below 10¹³ cm⁻³. The subfin of the fin 104 may be a group IV material having a band offset (e.g., valance band offset for P-type devices) from the channel portion. Example materials include, but are not limited to, Si or Si-rich SiGe. In some P-type transistor embodiments, the subfin of the fin 104 is Si and at least a portion of the subfin may also be doped with impurities (e.g., N-type) to a higher impurity level than the channel portion.

Turning to the first S/D region 114-1 and the second S/D region 114-2 on respective different sides of the gate stack 108, in some embodiments, the first S/D region 114-1 may be a source region and the second S/D region 114-2 may be a drain region. In other embodiments this designation of source and drain may be interchanged, i.e., the first S/D region 114-1 may be a drain region and the second S/D region 114-2 may be a source region. Although not specifically shown in FIG. 1, the FinFET 100 may further include S/D electrodes (also commonly referred to as "S/D contacts"), formed of one or more electrically conductive materials, for providing electrical connectivity to the S/D regions 114, respectively. In some embodiments, the S/D regions 114 of the FinFET 100 may be regions of doped semiconductors, e.g., regions of doped channel material of the fin 104, so as to supply charge carriers for the transistor channel. In some embodiments, the S/D regions 114 may be highly doped, e.g., with dopant concentrations of about 1·10²¹ cm⁻³, in order to advantageously form Ohmic contacts with the respective S/D electrodes, although these regions may also have lower dopant concentrations and may form Schottky contacts in some implementations. Irrespective of the exact doping levels, the S/D regions 114 of the FinFET 100 are the regions having dopant concentration higher than in other regions, e.g., higher than a dopant concentration in a region of the semiconductor channel material between the first S/D region 114-1 and the second S/D region 114-2, and, therefore, may be referred to as "highly doped" (HD) regions.

In some embodiments, the S/D regions 114 may generally be formed using either an implantation/diffusion process or an etching/deposition process. In the former process, dopants such as boron, aluminum, antimony, phosphorous, or arsenic may be ion-implanted into the one or more semiconductor materials of the upper portion of the fin 104 to form the S/D regions 114. An annealing process that activates the dopants and causes them to diffuse further into the fin 104 may follow the ion implantation process. In the latter process, the one or more semiconductor materials of the fin 104 may first be etched to form recesses at the locations for the future source and drain regions. An epitaxial deposition process may then be carried out to fill the recesses with material (which may include a combination of different materials) that is used to fabricate the S/D regions 114. In some implementations, the S/D regions 114 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114 may be formed using one or more alternate semiconductor materials such as germanium or a group III-V material or alloy. Although not specifically shown in the perspective illustration of FIG. 1, in further embodiments, one or more layers of metal and/or metal alloys may be used to form the source and drain contacts (i.e., electrical contacts to each of the S/D regions 114).

The FinFET 100 may have a gate length, GL, (i.e., a distance between the first S/D region 114-1 and the second S/D region 114-2), a dimension measured along the longitudinal axis of the fin 104, which extends in the direction of the x-axis of the example reference coordinate system x-y-z shown in the present drawings, where the gate length may, in some embodiments, be between about 5 and 40 nanometers, including all values and ranges therein (e.g. between about 22 and 35 nanometers, or between about 15 and 25 nanometers). The fin 104 may have a thickness, a dimension measured in the direction of the y-axis of the reference coordinate system x-y-z shown in FIG. 1, that may, in some embodiments, be between about 4 and 15 nanometers, including all values and ranges therein (e.g., between about 5 and 10 nanometers, or between about 7 and 12 nanometers). The fin 104 may have a height, a dimension measured in the direction of the z-axis of the reference coordinate system x-y-z shown in FIG. 1, which may, in some embodiments, be between about 30 and 350 nanometers, including all values and ranges therein (e.g., between about 30 and 200 nanometers, between about 75 and 250 nanometers, or between about 150 and 300 nanometers).

Although the fin 104 is illustrated in FIG. 1 and in some of the subsequent drawings (e.g., FIGS. 2-4) as having a rectangular cross-section in a z-y plane of the reference coordinate system shown in FIG. 1 and in FIGS. 2-4, the fin 104 may instead have a cross-section that is rounded or sloped at the "top" of the fin 104, and the gate stack 108 (including the different portions of the gate dielectric 110) may conform to this rounded or sloped fin 104. In use, the FinFET 100 may form conducting channels on three "sides" of the channel portion of the fin 104, potentially improving performance relative to single-gate transistors (which may form conducting channels on one "side" of a channel material or substrate) and double-gate transistors (which may form conducting channels on two "sides" of a channel material or substrate).

While FIG. 1 illustrates a single FinFET 100, in some embodiments, a plurality of FinFETs may be arranged next to one another (with some spacing in between) along the fin 104.

FIGS. 2-4 provide cross-sectional side views of example IC devices implementing signal routing using structures based on BPRs, according to various embodiments of the present disclosure. The IC devices shown in FIGS. 2-4 provide examples of how a plurality of the FinFETs 100 as shown in FIG. 1 may be arranged in IC devices. Therefore, the IC devices shown in FIGS. 2-4 illustrate some elements labeled with the same reference numerals as those used in FIG. 1 to indicate similar or analogous elements in these drawings, so that, in the interests of brevity, descriptions of a given element provided with reference to one drawing does not have to be repeated again for other drawings. For example, FIGS. 2-4 illustrate a plurality of the fins 104 of FIG. 1, where different instances of the fins 104 are shown in FIGS. 2-4 with a dash and a different reference numeral after the reference numeral for the fin, e.g., a fin 104-1, a fin 104-2, and so on. A legend provided within a dashed box at the bottom of FIGS. 2-4 illustrates colors/patterns used to indicate some portions or materials of some of the elements shown in FIG. 2, so that FIGS. 2-4 are not cluttered by too many reference numerals. For example, FIGS. 2-4 use different colors/patterns to identify the STI material 106, the gate stack 108, a BPR liner 212, and so on.

FIG. 2 illustrates an IC device 200 that includes a plurality of fins 104, which, in some embodiments, may extend substantially parallel to one another. FIG. 2 illustrates an embodiment where the longitudinal axis of each of the fins 104 extends along the direction of the x-axis (i.e., into the page of the drawing). The IC device 200 illustrates an example of 8 fins 104, labeled as fins 104-1 through 104-8, but, in other embodiments, any other number of two or more fins 104 may be implemented in the IC device 200, and/or the IC device 200 may include semiconductor structures other than the fins 104 along which transistors may be provided, e.g., nanoribbons.

Once the fins 104 are fabricated, metal gate lines may be provided over the fins 104, as represented in FIG. 2 by the gate stacks 108, where some of the metal gate lines may cross multiple fins 104. In some embodiments, the gate electrode material 112 used in a given gate stack 108 may have a material composition that is different from the material composition of the gate electrode material 112 used in another gate stack 108. For example, the fins 104-1 and 104-2 may be fins in which NMOS transistors can be formed, while the fins 104-3 and 104-4 may be fins in which PMOS transistors can be formed, in which case their gate electrode materials 112 may be different. FIG. 2 further illustrates that portions of the IC device 200 surrounding the upper portions of the fins 104 may be enclosed by the STI material 106, as described above. Portions of various components of the IC device 200 above the STI material 106 may be surrounded by an interlayer dielectric (ILD) material 206 that may include any of the insulator materials described above, but may, in some embodiments, have a different material composition from the STI material 106.

As also shown in FIG. 2, the IC device 200 may include one or more BPRs 210, shown in FIG. 2 as a BPR 210-1, a BPR 210-2, and a BPR 210-3, although in other embodiments more or less BPRs 210 may be implemented. While FIG. 2 illustrates the BPRs 210 in order to contrast them to the BSRs 220, in some embodiments, the IC device 200 may not include any BPRs. As further shown in FIG. 2, the IC device 200 further includes at least two BSRs 220, labeled as a BSR 220-1 and a BSR 220-2, although in other embodiments more BSRs 220 may be implemented. The BPRs 210 are configured to provide power to any of the IC components implemented in the IC device 200, while the BSRs 220 are configured to communicate signals between any two or more of the IC components implemented in the IC device 200.

The BPRs 210 and the BSRs 220 may be similar in that each may have a portion extending from a first face 202-1 of the support structure 102 towards a second face 202-2 of the support structure 102, which makes them at least partially "buried" in the support structure 102. Each of the BPRs 210 and the BSRs 220 may be provided in an opening in the support structure 102, the opening extending from the first face 202-1 of the support structure 102, where sidewalls of the opening may be lined with a liner material (shown in FIG. 2 as a BPR liner 212 for the BPRs 210 and as a BSR liner 222 for the BSRs 220), and where the lined opening is at least partially filled with an electrically conductive fill material (shown in FIG. 2 as a BPR fill material 214 for the BPRs 210 and as a BSR fill material 224 for the BSRs 220). In some embodiments, the liner material may be a dielectric material, to help electrically decouple the electrically conductive materials of the BPRs 210 and the BSRs 220 from various other electrically conductive materials of the IC device 200 (e.g., to help reduce undesired formation of conductive paths through the support structure 102). In other embodiments, the liner material may be an electrically conductive or semiconductor material, to decrease diffusion of the electrically conductive fill material into surrounding portions of the support structure 102. Thus, in various embodiments, the BPR liner 212 or the BSR liner 222 may include materials such as silicon nitride, silicon oxide, silicon dioxide, silicon carbide, silicon nitride doped with carbon, silicon oxynitride, or any other materials described herein with reference to the STI material 106, or materials such as tantalum, tantalum nitride, titanium nitride, tungsten carbide, or cobalt. Any of the BPR liner 212 or the BSR liner 222 may have a thickness between about 1 and 10 nanometers, including all values and ranges therein, e.g., between about 1 and 6 nanometers. In various embodiments, each of the BPR fill material 214 and the BSR fill material 224 may include any suitable electrically conductive material, which may include an alloy or a stack of multiple electrically conductive materials. In some embodiments, such electrically conductive materials may include one or more metals or metal alloys, with metals such as copper, ruthenium, palladium, platinum, cobalt, nickel, hafnium, zirconium, titanium, tantalum, and aluminum. In some embodiments, such electrically conductive materials may include one or more electrically conductive alloys oxides or carbides of one or more metals. In some embodiments, a material composition of the liner/ electrically conductive fill material of the BPRs 210 may be different from a material composition of the liner/ electrically conductive fill material of the BSRs 220. In other embodiments, material compositions of the liner/ electrically conductive fill material of the BPRs 210 may be substantially the same as those of the BSRs 220.

Where the BPRs 210 and the BSRs 220 start to differ is their coupling at the bottoms of these structures (i.e., portions closest to the second face 202-2 of the support structure 102). In particular, as shown in FIG. 2, the IC device 200 further includes a bottom BSR interconnect 232 that is electrically coupled (e.g., directly connected) to each of the bottom of the buried portion of the first BSR 220-1 and the buried portion of the second BSR 220-2, thus providing electrical connectivity and electrical continuity between the BSR fill material 224 of the first BSR 220-1 and the BSR fill material 224 of the second BSR 220-2. Neither the buried portion of the first BSR 220-1 nor the buried portion of the second BSR 220-2 reach the second face 202-2 of the support structure 102, and the bottom BSR interconnect 232 connects these portions in a way that the bottom BSR interconnect 232 is between the first face 202-1 and the second face 202-2 of the support structure 102. In this manner, the bottom BSR interconnect 232 forms a bridge interconnect or a bridge structure that has a first end in contact with the electrically conductive fill material 224 of the buried portion of the first BSR 220-1 and has a second end in contact with the electrically conductive fill material 224 of the buried portion of the second BSR 220-2, the bridge interconnect being embedded within the support structure 102. In other words, the bottom BSR interconnect 232 may be entirely embedded in the support structure 102 so that it is below the first face 202-1 but above the second face 202-2. In some embodiments, the bridge structure of the bottom BSR interconnect 232 may include a first conductive via 242-1, electrically coupled (e.g., directly connected) to a bottom of the first BSR 220-1 and a second conductive via 242-2, electrically coupled (e.g., directly connected) to a bottom of the second BSR 220-2, and a conductive line 244, electrically coupled (e.g., directly connected) to the first conductive via 242-1 and the second conductive via 242-2, as shown in FIG. 2. Each of the first conductive via 242-1 and the second conductive via 242-2 may extend towards, but not reach, the second face 202-2 of the support structure 102, so that the conductive line 244 is also above the second face 202-2 and each of the first conductive via 242-1, the second conductive via 242-2, and the conductive line 244 is embedded in the support structure 102.

As the foregoing illustrates, connectivity between the first and second BSRs 220-1, 220-2 is entirely within the support structure 102, where neither the bottom BSR interconnect 232 reaches the second face 202-2 of the support structure 102, nor are there any other electrical connections that are directly connected to any of the BSRs 220 and are available for being contacted at the second face 202-2 of the support structure 102. On the other hand, the BPRs 210 often are connected to BPR interconnects 216 that may extend from the bottoms of the BPRs 210 to the second face 202-2 of the support structure 102, as shown in FIG. 2. Such interconnects 216 may be referred to as "backside BPR interconnects." In some embodiments, the interconnects 216 implemented as backside BPR interconnects may be vias, as shown in FIG. 2.

The BPRs 210 and the BSRs 220 may also be similar in that each may be coupled to one or more terminals of one of more IC components provided in the IC device 200, e.g., to various transistor terminals of the FinFETs 100 that may be provided along any of the fins 104 of the IC device 200. However, this is also where the BPRs 210 and the BSRs 220 may start to differ. Because the BPRs 210 are configured to provide power to any of the IC components implemented in the IC device 200, they may be coupled to the S/D regions 114 of any of the FinFETs 100 but they would typically not be coupled to the gates of these transistors. On the other hand, any of the BSRs 220 may be coupled to the gates of any of the FinFETs 100, as well as to the S/D regions 114 of any of the FinFETs 100. In order to couple to various terminals of the IC components implemented in the IC device 200, an individual BSR 220 may be electrically coupled to (e.g., be on conductive contact with) a top BSR interconnect 234, which may then be electrically coupled to (e.g., be on conductive contact with) a respective terminal of one of the IC components implemented in the IC device 200. For example, as shown in FIG. 2, a first top BSR interconnect 234-1 may be electrically coupled (e.g., directly connected) to the first BSR 220-1, and may also be coupled to a terminal of a first transistor of the plurality of transistors implemented in any of the fins 104, while a second top BSR interconnect 234-2 may be electrically coupled (e.g., directly connected) to the second BSR 220-2, and may also be coupled to a terminal of a second transistor of the plurality of transistors implemented in any of the fins 104 (coupling to the terminals of the transistors is not specifically shown in FIG. 2 because many different such possibilities exist). For example, in some embodiments, the first top BSR interconnect 234-1 may be electrically coupled to a gate terminal of a first transistor (e.g., a first FinFET 100) implemented based on any of the fins 104 of the IC device 200, while the second top BSR interconnect 234-2 may be electrically coupled to a source terminal or a drain terminal of a second transistor (e.g., a second FinFET 100) implemented based on any of the fins 104 of the IC device 200. As shown in FIG. 2, the first top BSR interconnect 234-1 may be connected to a portion of first BSR 220-1 that is above the first face 202-1 of the support structure 102 (i.e., to a portion of the first BSR 220-1 that is the farthest away from the second face 202-2 of the support structure 102), and, similarly, the second top BSR interconnect 234-2 may be connected to a portion of second BSR 220-2 that is above the first face 202-1 of the support structure 102.

In some embodiments, the BPRs 210 and the BSRs 220 may further differ in their dimensions. For example, in some embodiments, a width (i.e., a dimension measured along the y-axis of the example coordinate system shown) of an individual one of the BSRs 220 may be smaller (e.g., at least about 10% smaller or at least about 20% smaller) than a width of an individual one of the BPRs 210. In some embodiments, a length (i.e., a dimension measured along the x-axis of the example coordinate system shown) of an individual one of the BSRs 220 may be smaller (e.g., at least about 10% smaller or at least about 20% smaller) than a length of an individual one of the BPRs 210. In some embodiments, a depth (i.e., a dimension measured along the z-axis of the example coordinate system shown) to which an individual one of the BSRs 220 is buried in the support structure 102 may be smaller (e.g., at least about 10% smaller or at least about 20% smaller) than that of an individual one of the BPRs 210. However, in other embodiments, any of the dimensions of the BSRs 220 may be substantially the same and/or comparable to those of the BPRs 210. It should be noted that while the BSRs 220-1 and 220-2 are illustrated in FIG. 2 to be relatively close to one another (namely, only separated by four fins 104), in other embodiments, the distance between the BSRs 220 that are connected by the bottom BSR interconnect 232 (i.e., a dimension measured along the y-axis of the example coordinate system shown) may be much larger.

FIG. 2 further illustrates one layer of a metallization stack 250 having interconnects 252 (only one of which is labeled in FIG. 2) that may be coupled to one or more terminals of the transistors or other IC components of the IC device 200. The metallization stack 250 is illustrated to highlight the fact that the transistors or other IC components of the IC device 200 are between the second face 202-2 of the support structure 102 and the metallization stack 250, while each of the first BSR 220-1 and the second BSR 220-2 is between the bottom BSR interconnect 232 and the metallization stack 250 (i.e., the first and second BSRs 220 are below the metallization stack 250).

In various embodiments, any of the interconnects described herein, e.g., the interconnects 252, the BPR interconnects 216, the bottom BSR interconnect 232, or the top BSR interconnect 234 may include any suitable electrically conductive materials, such as any of those listed above for the electrically conductive fill materials of the BPRs 210 and the BSRs 220.

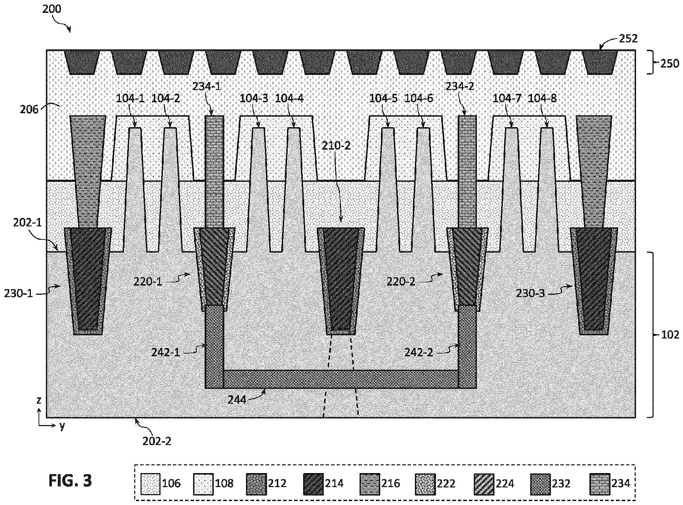

FIG. 3 provides a cross-sectional side view of an example IC device 300 implementing signal routing using structures based on BPRs, according to other embodiments of the present disclosure. The IC device 300 is substantially the same as the IC device 200, except that the BPR interconnects 216 are "frontside BPR interconnects" in that they extend from the tops of the BPRs 210 away from the first face 202-1 of the support structure. Other descriptions provided with respect to the IC device 200 are applicable to the IC device 300 and, therefore, in the interests of brevity, are not repeated.

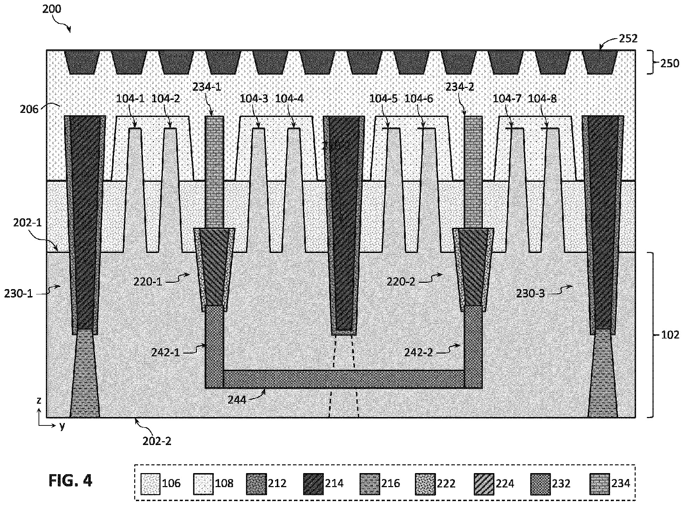

FIG. 4 provides a cross-sectional side view of an example IC device 400 implementing signal routing using structures based on BPRs, according to yet other embodiments of the present disclosure. The IC device 400 is substantially the same as the IC device 200, except that it shows that, in some embodiments, the BPRs 210 may extend away from the support structure 102 to approximately the level of the gate stacks 108. Other descriptions provided with respect to the IC device 200 are applicable to the IC device 400 and, therefore, in the interests of brevity, are not repeated.

The IC devices 200, 300, and 400 illustrated in the present drawings, do not represent an exhaustive set of IC devices in which signal routing using structures based on BPRs, e.g., any of the BSRs 220 and their associated bottom BSR interconnects 232, as described herein may be implemented, but merely provide examples of such devices. For example, although FIGS. 2-4 illustrate fins 104 based on which FinFETs 100 as described herein may be implemented, in general, any of the BSRs 220 may be used to provide electrical connectivity between any IC components within the IC devices 200, 300, and 400, such as transistors, capacitors, resistors, and diodes. In various embodiments, any of the features described with reference to one of the IC devices of FIGS. 1-4 may be combined with any of the features described with reference to another one of the IC devices of FIGS. 1-4.

Although particular arrangements of materials are discussed with reference to FIGS. 1-4, intermediate materials may be included in various portions of these figures. Note that FIGS. 1-4 are intended to show relative arrangements of some of the components therein, and that various device components of these figures may include other components that are not specifically illustrated, e.g., various interfacial layers or various additional components or layers. Additionally, although some elements of the IC devices are illustrated in FIGS. 1-4 as being planar rectangles or formed of rectangular solids, this is simply for ease of illustration, and embodiments of various ones of these elements may be curved, rounded, or otherwise irregularly shaped as dictated by, and sometimes inevitable due to, the manufacturing processes used to fabricate semiconductor device assemblies. Therefore, descriptions of various embodiments of IC devices implementing signal routing using structures based on BPRs, provided herein, are equally applicable to embodiments where various elements of the resulting IC devices look different from those shown in the figures due to manufacturing processes used to form them.

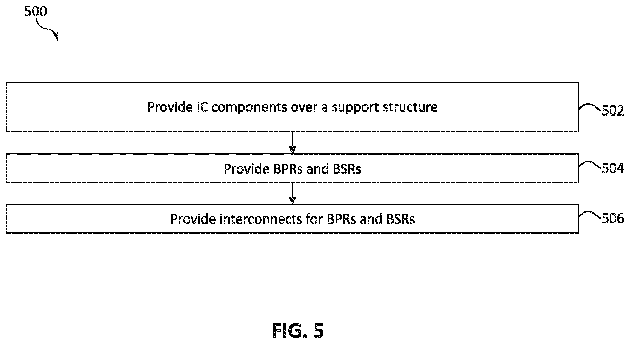

The IC devices implementing signal routing using structures based on BPRs as described herein (e.g., any embodiments of the IC devices 200, 300, or 400 including the BSRs 220) may be manufactured using any suitable techniques. FIG. 5 provides a flow diagram of an example method 500 of manufacturing an IC device implementing signal routing using structures based on BPRs (e.g., any embodiments of the IC devices 200, 300, or 400 including the BSRs 220), according to some embodiments of the present disclosure. However, other examples of manufacturing any of the IC devices described herein, as well as larger devices and assemblies that include such structures (e.g., as shown in FIGS. 6-9) are also within the scope of the present disclosure.

In FIG. 5, although the operations are illustrated once each and in a particular order, the operations may be performed in any suitable order and repeated as desired. For example, one or more operations may be performed in parallel to manufacture, substantially simultaneously, multiple signal routing structures that are based on BPRs (e.g., to manufacture multiple BSRs 220 and their corresponding bottom BSR interconnects 232) as described herein. In another example, the operations may be performed in a different order to reflect the structure of a particular device assembly in which one or more nanoribbon-based capacitors as described herein will be included. In addition, the example manufacturing method shown in FIG. 5 may include other operations not specifically shown in this drawing, such as various cleaning or planarization operations as known in the art. For example, in some embodiments, the support structure 102, as well as layers of various other materials subsequently deposited thereon/in, may be cleaned prior to, after, or during any of the processes of the methods shown in FIG. 5, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the IC devices/assemblies described herein may be planarized prior to, after, or during any of the processes of the methods shown in FIG. 5, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

The method 500 may begin with a process 502 in which IC components such as transistors, resistors, capacitors, or diodes, support structure are provided over a support structure. The support structure used in the process 502 may be the support structure 102 as described above and the IC components provided in the process 502 may include a plurality of FinFETs 100 provided over one or more fins 104, as described above. Any known techniques for providing IC components over support structures may be used in the process 502.

The method 500 may include a process 504 in which BPRs and BSRs are provided. The BPRs and BSRs provided in the process 504 may include zero or more BPRs 210 as described above and two or more BSRs 220 as described above, together with the associated bottom BSR interconnects 232, as described above. Any known techniques for forming the BPRs 210 may also be used in the process 504 to provide the BSRs 220, but further include providing the bottom BSR interconnect 232 for a pair of the BSRs 220, as described herein.

The method 500 may include a process 506 in which interconnects are provided to electrically couple to the BPRs and BSRs provided in the process 504. The interconnects provided in the process 506 may include the BPR interconnects 216 and the top BSR interconnects 234, as described above. Any known techniques for forming interconnects may be used to provide the interconnects in the process 506.

IC devices implementing signal routing using structures based on BPRs, as disclosed herein may be included in any suitable electronic device or component. FIGS. 6-9 illustrate various examples of devices and components that may include one or more IC devices implementing signal routing using structures based on BPRs as disclosed herein.

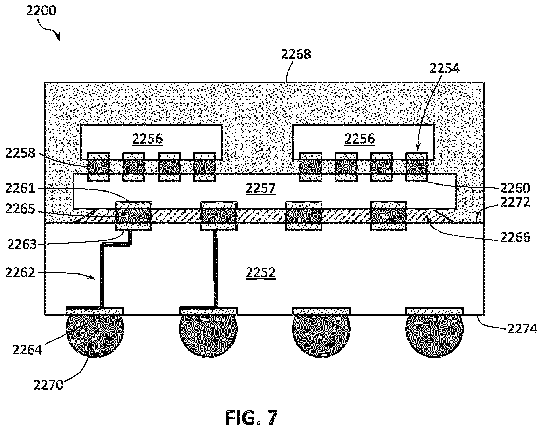

FIG. 6 are top views of a wafer 2000 and dies 2002 that may include one or more IC devices implementing signal routing using structures based on BPRs in accordance with any of the embodiments disclosed herein. In some embodiments, the dies 2002 may be included in an IC package, in accordance with any of the embodiments disclosed herein. For example, any of the dies 2002 may serve as any of the dies 2256 in an IC package 2200 shown in FIG. 7. The wafer 2000 may be composed of semiconductor material and may include one or more dies 2002 having IC structures formed on a surface of the wafer 2000. Each of the dies 2002 may be a repeating unit of a semiconductor product that includes any suitable IC (e.g., ICs including one or more IC devices implementing signal routing using structures based on BPRs as described herein). After the fabrication of the semiconductor product is complete (e.g., after manufacture of one or more IC devices implementing signal routing using structures based on BPRs as described herein, e.g., after manufacture of any embodiments of the IC devices as described with reference to FIGS. 2-4), the wafer 2000 may undergo a singulation process in which each of the dies 2002 is separated from one another to provide discrete "chips" of the semiconductor product. In particular, devices that include one or more IC devices implementing signal routing using structures based on BPRs as disclosed herein may take the form of the wafer 2000 (e.g., not singulated) or the form of the die 2002 (e.g., singulated). The die 2002 may include one or more transistors (e.g., FinFETs as described herein), diodes resistors, capacitors, and other IC components as well as, optionally, supporting circuitry to route electrical signals to the IC devices implementing signal routing using structures based on BPRs and various other IC components. In some embodiments, the wafer 2000 or the die 2002 may implement an electrostatic discharge (ESD) protection device, an RF FE device, a memory device (e.g., a static random-access memory (SRAM) device), a logic device (e.g., an AND, OR, NAND, or NOR gate), or any other suitable circuit element. Multiple ones of these devices may be combined on a single die 2002.

FIG. 7 is a side, cross-sectional view of an example IC package 2200 that may include one or more IC devices implementing signal routing using structures based on BPRs in accordance with any of the embodiments disclosed herein. In some embodiments, the IC package 2200 may be a system-in-package (SiP).

As shown in FIG. 7, the IC package 2200 may include a package substrate 2252. The package substrate 2252 may be formed of a dielectric material (e.g., a ceramic, a glass, a combination of organic and inorganic materials, a buildup film, an epoxy film having filler particles therein, etc., and may have embedded portions having different materials), and may have conductive pathways extending through the dielectric material between the face 2272 and the face 2274, or between different locations on the face 2272, and/or between different locations on the face 2274.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 7 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 7 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

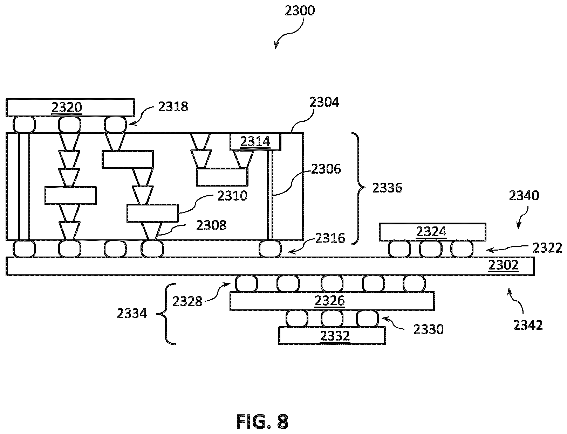

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 7 are solder balls (e.g., for a ball grid array arrangement), but any suitable second-level interconnects 2270 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 8.

The dies 2256 may take the form of any of the embodiments of the die 2002 discussed herein and may include any of the embodiments of an IC device implementing signal routing using structures based on BPRs, e.g., any embodiments of the IC devices as described with reference to FIGS. 2-4. In embodiments in which the IC package 2200 includes multiple dies 2256, the IC package 2200 may be referred to as a multi-chip package (MCP). Importantly, even in such embodiments of an MCP implementation of the IC package 2200, one or more IC devices implementing signal routing using structures based on BPRs may be provided in a single chip, in accordance with any of the embodiments described herein. The dies 2256 may include circuitry to perform any desired functionality. For example, one or more of the dies 2256 may be logic dies, including one or more IC devices implementing signal routing using structures based on BPRs as described herein, one or more of the dies 2256 may be memory dies (e.g., high bandwidth memory) with one or more IC devices implementing signal routing using structures based on BPRs, etc. In some embodiments, any of the dies 2256 may include one or more IC devices implementing signal routing using structures based on BPRs, e.g., as discussed above; in some embodiments, at least some of the dies 2256 may not include any IC devices implementing signal routing using structures based on BPRs.

The IC package 2200 illustrated in FIG. 7 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 7, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 8 is a cross-sectional side view of an IC device assembly 2300 that may include components having one or more IC devices implementing signal routing using structures based on BPRs in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of the IC devices implementing signal routing using structures based on BPRs in accordance with any of the embodiments disclosed herein; e.g., any of the IC packages discussed below with reference to the IC device assembly 2300 may take the form of any of the embodiments of the IC package 2200 discussed above with reference to FIG. 7 (e.g., may include one or more IC devices implementing signal routing using structures based on BPRs in/on a die 2256).

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 8 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 8), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 6), an IC device (e.g., any embodiments of the IC devices as described with reference to FIGS. 2-4), or any other suitable component. In particular, the IC package 2320 may include one or more IC devices implementing signal routing using structures based on BPRs as described herein. Although a single IC package 2320 is shown in FIG. 8, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 8, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, ESD protection devices, and memory devices. More complex devices such as further RF devices, power amplifiers, power management devices, antennas, arrays, sensors, and microelectromechanical systems (MEMS) devices may also be formed on the interposer 2304. In some embodiments, the IC devices implementing signal routing using structures based on BPRs as described herein may also be implemented in/on the interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 8 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

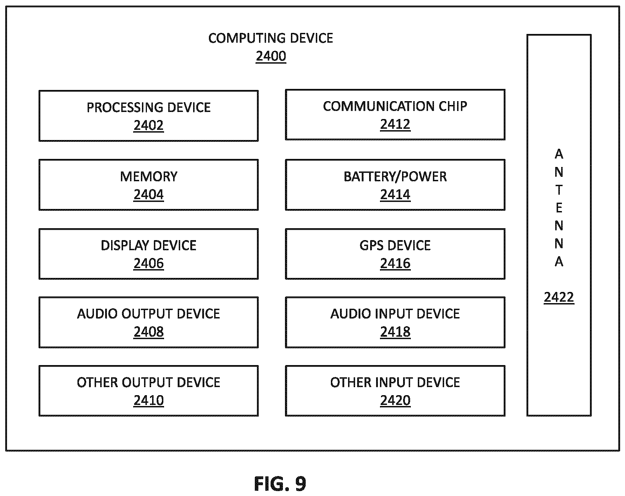

FIG. 9 is a block diagram of an example computing device 2400 that may include one or more components with one or more IC devices implementing signal routing using structures based on BPRs in accordance with any of the embodiments disclosed herein. For example, any suitable ones of the components of the computing device 2400 may include a die (e.g., the die 2002 of FIG. 6) including one or more IC devices implementing signal routing using structures based on BPRs in accordance with any of the embodiments disclosed herein. Any of the components of the computing device 2400 may include an IC device (e.g., any embodiment of the IC devices of FIGS. 2-4) and/or an IC package (e.g., the IC package 2200 of FIG. 7). Any of the components of the computing device 2400 may include an IC device assembly (e.g., the IC device assembly 2300 of FIG. 8).

A number of components are illustrated in FIG. 9 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system-on-chip (SoC) die.

Additionally, in various embodiments, the computing device 2400 may not include one or more of the components illustrated in FIG. 9, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408 but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid-state memory, and/or a hard drive. In some embodiments, the memory 2404 may include memory that shares a die with the processing device 2402. This memory may be used as cache memory and may include, e.g., eDRAM, and/or spin transfer torque magnetic random-access memory (STT-MRAM).

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

In various embodiments, IC devices implementing signal routing using structures based on BPRs as described herein may be particularly advantageous for use as part of ESD circuits protecting power amplifiers, low-noise amplifiers, filters (including arrays of filters and filter banks), switches, or other active components. In some embodiments, IC devices implementing signal routing using structures based on BPRs as described herein may be used in PMICs, e.g., as a rectifying diode for large currents. In some embodiments, IC devices implementing signal routing using structures based on BPRs as described herein may be used in audio devices and/or in various input/output devices.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides an IC device that includes a support structure (e.g., a substrate, a wafer, a die, or a chip) having a first face (e.g., 202-1) and an opposing second face (e.g., 202-2); a plurality of transistors provided over the first face of the support structure; a BPR (e.g., 210-1), having a portion that extends from the first face towards the second face of the support structure; a first BSR (e.g., 220-1) and a second BSR (e.g., 220-2), each having a portion that extends from the first face towards the second face of the support structure, where at least one of the first BSR and the second BSR is coupled to a terminal of at least one of the plurality of transistors; and a bottom BSR interconnect (e.g., 232), electrically coupled (e.g., directly connected) to each of the portion of the first BSR and the portion of the second BSR.

Example 2 provides the IC device according to example 1, where the portion of the first BSR does not reach the second face of the support structure, the portion of the second BSR does not reach the second face of the support structure, and the bottom BSR interconnect is electrically coupled to a bottom of the portion of the first BSR and a bottom of the portion of the second BSR (where the bottoms of these portions refer to the parts of the BSRs closest to the second face of the support structure).

Example 3 provides the IC device according to examples 1 or 2, where the bottom BSR interconnect is between the first face of the support structure and the second face of the support structure (in other words, the bottom BSR interconnects is entirely embedded in the support structure, i.e., is below the first face of the support structure but above the second face of the support structure).

Example 4 provides the IC device according to any one of the preceding examples, where the bottom BSR interconnect does not reach the second face of the support structure.

Example 5 provides the IC device according to any one of the preceding examples, further including a first top BSR interconnect (e.g., 234-1) and a second top BSR interconnect (e.g., 234-2), where the first top BSR interconnect is electrically coupled (e.g., directly connected) to each of the first BSR and a terminal of a first transistor of the plurality of transistors, and the second top BSR interconnect is electrically coupled (e.g., directly connected) to each of the second BSR and a terminal of a second transistor of the plurality of transistors.

Example 6 provides the IC device according to example 5, where the first top BSR interconnect is electrically coupled (e.g., directly connected) to a portion of the first BSR that above the first face of the support structure (e.g., to a portion of the first BSR that is the farthest from the second face of the support structure), and the second top BSR interconnect is electrically coupled (e.g., directly connected) to a portion of the second BSR that above the first face of the support structure (e.g., to a portion of the first BSR that is the farthest from the second face of the support structure).

Example 7 provides the IC device according to examples 5 or 6, where at least one of the terminal of the first transistor and the terminal of the second transistor is a gate terminal. This is in contrast to BPRs which are typically not electrically coupled to the gate terminals of transistors.

Example 8 provides the IC device according to any one of examples 5-7, where the terminal of the first transistor is a gate terminal and the terminal of the second transistor is a source terminal or a drain terminal.

Example 9 provides the IC device according to any one of the preceding examples, where each of a width of the first BSR and a width of the second BSR is smaller than a width of the BPR, e.g., at least about 10% smaller or at least about 20% smaller. In other embodiments, this may be reversed.

Example 10 provides the IC device according to any one of the preceding examples, further including a metallization stack having interconnects coupled to one or more terminals of one or more transistors of the plurality of transistors, where the plurality of transistors are between the second face of the support structure and the metallization stack (i.e., the metallization stack is above the plurality of transistors), and each of the first BSR and the second BSR is between the bottom BSR interconnect and the metallization stack (i.e., the first and second BSRs are below the metallization stack).

Example 11 provides the IC device according to any one of the preceding examples, further including a backside BPR interconnect (e.g., 216 as shown in FIG. 2), having a first end electrically coupled (e.g., directly connected) to the BPR and having a second end at the second face of the support structure.

Example 12 provides the IC device according to example 11, where the backside BPR interconnect is electrically coupled (e.g., directly connected) to a bottom of the portion of the BPR (i.e., a part of the BPR closest to the second face of the support structure), and the backside BPR interconnect is a via.

Example 13 provides the IC device according to any one of the preceding examples, where each portion of the portion of the BPR, the portion of the first BSR, and the portion of the second BSR includes a liner on sidewalls of the portion and an electrically conductive fill material at least partially filling the portion.

Example 14 provides the IC device according to any one of the preceding examples, where a material composition of the liner of a first one of the portion of the BPR, the portion of the first BSR, and the portion of the second BSR is different from a material composition of the liner of a second one of the portion of the BPR, the portion of the first BSR, and the portion of the second BSR, and/or a material composition of the electrically conductive fill material of the first one of the portion of the BPR, the portion of the first BSR, and the portion of the second BSR is different from a material composition of the electrically conductive fill material of the second one of the portion of the BPR, the portion of the first BSR, and the portion of the second BSR.

Example 15 provides an IC device that includes a support structure (e.g., support structure 102, such as a substrate, a wafer, a chip, or a die) having a first face (e.g., 202-1) and an opposing second face (e.g., 202-2); a plurality of IC components provided over the first face of the support structure; a first structure (e.g., 220-1) and a second structure (e.g., 220-2), each having a portion that is buried in the support structure and includes an electrically conductive fill material, where at least one of the first structure and the second structure is electrically coupled (e.g., directly connected) to a terminal of at least one of the plurality of IC components; and a bridge interconnect (e.g., 232), having a first end in contact with the electrically conductive fill material of the portion of the first structure, further having a second end in contact with the electrically conductive fill material of the portion of the second structure, and embedded within the support structure (i.e., is below the first face of the support structure but above the second face of the support structure).

Example 16 provides the IC device according to example 15, where the bridge interconnect includes a first conductive via, electrically coupled (e.g., directly connected) to a bottom of the first structure and extending towards, but not reaching, the second face of the support structure; a second conductive via, electrically coupled (e.g., directly connected) to a bottom of the second structure and extending towards, but not reaching, the second face of the support structure; and a conductive line, electrically coupled (e.g., directly connected) to the first conductive via and the second conductive via.

Example 17 provides the IC device according to example 16, where each of the first conductive via, the second conductive via, and a conductive line is embedded in the support structure (i.e., is below the first face of the support structure but above the second face of the support structure).

Example 18 provides the IC device according to any one of examples 15-17, where the plurality of IC components includes one or more of transistors, capacitors, resistors, and diodes.

Example 19 provides an IC package that includes an IC device according to any one of the preceding examples; and a further IC component, coupled to the IC device.

Example 20 provides the IC package according to example 19, where the further IC component includes one of a package substrate, an interposer, or a further IC die, and/or where the IC device includes, or is a part of, at least one of a memory device, a computing device, a wearable device, a handheld electronic device, and a wireless communications device.

Example 21 provides an electronic device that includes a carrier substrate; and one or more of the IC device according to any one of the preceding examples and the IC package according to any one of the preceding examples, coupled to the carrier substrate.

Example 22 provides the electronic device according to example 21, where the carrier substrate is a motherboard.

Example 23 provides the electronic device according to example 21, where the carrier substrate is a PCB.

Example 24 provides the electronic device according to any one of examples 21-23, where the electronic device is a wearable electronic device (e.g., a smart watch) or handheld electronic device (e.g., a mobile phone).

Example 25 provides the electronic device according to any one of examples 21-24, where the electronic device further includes one or more communication chips and an antenna.

Example 26 provides the electronic device according to any one of examples 21-25, where the electronic device is an RF transceiver.

Example 27 provides the electronic device according to any one of examples 21-25, where the electronic device is one of a switch, a power amplifier, a low-noise amplifier, a filter, a filter bank, a duplexer, an upconverter, or a downconverter of an RF communications device, e.g., of an RF transceiver.

Example 28 provides the electronic device according to any one of examples 21-25, where the electronic device is a computing device.

Example 29 provides the electronic device according to any one of examples 21-28, where the electronic device is included in a base station of a wireless communication system.

Example 30 provides the electronic device according to any one of examples 21-28, where the electronic device is included in a UE device (i.e., a mobile device) of a wireless communication system.

Example 31 provides a method of fabricating an IC device. The method includes providing a plurality of IC components over a first face of a support structure; providing a BPRs having a portion that extends from the first face towards a second face of the support structure; providing a first BSR and a second BSR, each having a portion that extends from the first face towards the second face of the support structure, where the first BSR is electrically coupled to a terminal of a first IC component of the plurality of IC components and the second BSR is electrically coupled to a terminal of a second IC component of the plurality of IC components; and providing a bottom BSR interconnect, electrically coupled (e.g., directly connected) to each of the portion of the first BSR and the portion of the second BSR.

Example 32 provides the method according to example 31, where the bottom BSR interconnect includes a first conductive via, electrically coupled (e.g., directly connected) to a bottom of the portion of the first BSR and extending towards, but not reaching, the second face of the support structure; a second conductive via, electrically coupled (e.g., directly connected) to a bottom of the portion of the second BSR and extending towards, but not reaching, the second face of the support structure; and a conductive line, electrically coupled (e.g., directly connected) to the first conductive via and the second conductive via.

Example 33 provides the method according to examples 31 or 32, further including processes for forming the IC device according to any one of the preceding examples (e.g., for forming the IC device according to any one of examples 1-18).

Example 34 provides the method according to any one of examples 31-33, further including processes for forming the IC package according to any one of the preceding examples (e.g., for forming the IC package according to any one of examples 19-20).

Example 35 provides the method according to any one of examples 31-35, further including processes for forming the electronic device according to any one of the preceding examples (e.g., for forming the electronic device according to any one of examples 21-30).

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a support structure having a first face and an opposing second face;
a plurality of transistors over the first face of the support structure;
a first buried signal rail (BSR) and a second BSR, each having a portion that extends from the first face towards the second face of the support structure, where at least one of the first BSR and the second BSR is coupled to a terminal of at least one of the plurality of transistors; and
a bottom BSR interconnect in the support structure, the bottom BSR interconnect coupled to the portion of the first BSR and the portion of the second BSR.

2. The IC device according to claim 1, wherein:
the portion of the first BSR does not reach the second face of the support structure,
the portion of the second BSR does not reach the second face of the support structure, and
the bottom BSR interconnect is coupled to a bottom of the portion of the first BSR and a bottom of the portion of the second BSR.

3. The IC device according to any one of the preceding claims, wherein the bottom BSR interconnect is between the first face of the support structure and the second face of the support structure.

4. The IC device according to any one of the preceding claims, wherein the bottom BSR interconnect does not reach the second face of the support structure.

5. The IC device according to any one of the preceding claims, further comprising a first top BSR interconnect and a second top BSR interconnect, wherein:
the first top BSR interconnect is coupled to the first BSR and a terminal of a first transistor of the plurality of transistors, and
the second top BSR interconnect is coupled to the second BSR and a terminal of a second transistor of the plurality of transistors.

6. The IC device according to claim 5, wherein:
the first top BSR interconnect is coupled to a portion of the first BSR that above the first face of the support structure, and
the second top BSR interconnect is coupled to a portion of the second BSR that above the first face of the support structure.

7. The IC device according to any one of claims 5-6, wherein at least one of the terminal of the first transistor and the terminal of the second transistor is a gate terminal.

8. The IC device according to any one of claims 5-7, wherein the terminal of the first transistor is a gate terminal and the terminal of the second transistor is a source terminal or a drain terminal.

9. The IC device according to any one of the preceding claims, wherein:
the IC device further includes a buried power rail (BPR), having a portion that extends from the first face towards the second face of the support structure, and
each of a width of the first BSR and a width of the second BSR is smaller than a width of the BPR.

10. The IC device according to any one of the preceding claims, further comprising a metallization stack having interconnects coupled to one or more terminals of one or more transistors of the plurality of transistors, wherein:
the plurality of transistors are between the second face of the support structure and the metallization stack, and
each of the first BSR and the second BSR is between the bottom BSR interconnect and the metallization stack.

11. The IC device according to any one of the preceding claims, further comprising:
a buried power rail (BPR), having a portion that extends from the first face towards the second face of the support structure; and
a backside BPR interconnect, having a first end coupled to the BPR and having a second end at the second face of the support structure.

12. The IC device according to claim 11, wherein:
the backside BPR interconnect is coupled to a bottom of the portion of the BPR, and
the backside BPR interconnect is a via.

13. The IC device according to any one of the preceding claims, wherein:
the IC device further includes a buried power rail (BPR), having a portion that extends from the first face towards the second face of the support structure, and
each portion of the portion of the BPR, the portion of the first BSR, and the portion of the second BSR includes a liner on sidewalls of the portion and an electrically conductive fill material at least partially filling the portion.

14. The IC device according to any one of the preceding claims, wherein:
the IC device further includes a buried power rail (BPR), having a portion that extends from the first face towards the second face of the support structure, and
a material composition of the liner of a first one of the portion of the BPR, the portion of the first BSR, and the portion of the second BSR is different from a material composition of the liner of a second one of the portion of the BPR, the portion of the first BSR, and the portion of the second BSR.

15. The IC device according to any one of claims 1-13, wherein:
the IC device further includes a buried power rail (BPR), having a portion that extends from the first face towards the second face of the support structure, and
a material composition of the electrically conductive fill material of the first one of the portion of the BPR, the portion of the first BSR, and the portion of the second BSR is different from a material composition of the electrically conductive fill material of the second one of the portion of the BPR, the portion of the first BSR, and the portion of the second BSR.
